# Europäisches Patentamt
## European Patent Office
## Office européen des brevets

(19)

(11) Veröffentlichungsnummer: **0 010 173**
**B1**

(12) **EUROPÄISCHE PATENTSCHRIFT**

(45) Veröffentlichungstag der Patentschrift:
02.03.83

(51) Int. Cl.³: **G 01 R 31/28**, G 06 F 11/26

(21) Anmeldenummer: **79103513.2**

(22) Anmeldetag: **19.09.79**

(54) Halbleiterplättchen mit verbesserter Prüfbarkeit der monolithisch hochintegrierten Schaltungen.

(30) Priorität: **16.10.78 US 951891**

(43) Veröffentlichungstag der Anmeldung:
**30.04.80 Patentblatt 80/9**

(45) Bekanntmachung des Hinweises auf die Patenterteilung:
**02.03.83 Patentblatt 83/9**

(84) Benannte Vertragsstaaten:
**DE FR GB**

(56) Entgegenhaltungen:
**DE-A-2 413 805**
**US-A-3 790 885**
**US-A-3 815 025**
**IBM TECHNICAL DISCLOSURE BULLETIN. Vol. 14, Nr. 10, März 1972, New York, US, A.D. SAVKAR: »N-way testpoint for complex LSI design«, Seiten 2937, 2938**

(73) Patentinhaber: **International Business Machines Corporation, Armonk, N.Y. 10504 (US)**

(72) Erfinder: **Doty Jr., Charles Randall, 200 Charing Cross Drive, Matthews, NC 28105 (US)**
Erfinder: **Muehldorf, Eugen Igor, 8717 Liberty Ln., Potomac, Md. 20854 (US)**
Erfinder: **Shah, Himanshu Gamanlal, 3096 Bale Hollow Drive, Lexington, KY 40502 (US)**

(74) Vertreter: **Neuland, Johannes, Dipl.-Ing., Schönaicher Strasse 220, D-7030 Böblingen (DE)**

## Halbleiterplättchen mit verbesserter Prüfbarkeit der monolithisch hochintegrierten Schaltungen

Die Erfindung bezieht sich auf ein Halbleiterplättchen mit verbesserter Prüfbarkeit der monolithisch hochintegrierten Schaltungen, das eingebettete, d. h. von den Eingangs- und Ausgangsanschlüssen des Halbleiterplättchens direkt nicht zugängliche programmierbare logische Anordnungen, im folgenden kurz als PLA bezeichnet, sowie lineare logische Funktionen realisierende Schaltungen und der Aufnahme von Prüfbitmustern und Prüfergebnissen dienende Schieberegister aufweist.

Beim Entwurf von monolithisch hochintegrierten Halbleiterschaltungen gibt es vier wesentliche konkurrierende Regeln, die in Betracht gezogen werden müssen: 1) logischer Entwurf, 2) physikalischer Entwurf, 3) Prüfmustererzeugung und 4) Freigabe für die Fertigung. Beispielsweise muß außer der Forderung, die logischen Strukturen so zu entwerfen, daß sie gut herstellbar sind, auch die Forderung berücksichtigt werden, die logischen Strukturen so zu entwerfen, daß sie gemäß Punkt 3) oben wirksam geprüft werden können. In diesem Zusammenhang wurde in den US-Patenten 3 783 254 und 3 761 695 für den Entwurf der kombinatorischen logischen Schaltungen die Beschränkung angewandt, daß sie für Prüfzwecke aufgeteilt werden konnten.

Wenn sie jedoch gemäß Punkt 2) oben für einen wirksamen physikalischen Entwurf ausgelegt wurden, wurden die logischen Strukturen in solcher Weise unterteilt, daß die kombinatorische Logik durch Makro-Strukturen beschrieben wird, überwiegend durch programmierbare logische Anordnungen (PLA), was im allgemeinen dazu führt, daß eine PLA eine andere speist. PLA können geprüft werden durch Nachbilden der PLA als Blöcke aus Grundverknüpfungsgliedern. Sie lassen sich jedoch wirksamer prüfen als sogenannte Makro-Strukturen. Für die Zwecke der Erfindung gehören zu einer Makro-Struktur diejenigen Gruppen von Schaltungselementen, die in einer bestimmten physikalischen Anordnung entsprechend der gewünschten auszuführenden logischen Funktion angeordnet sind und der Konstrukteur schreibt die gewünschte logische Funktion vor, so daß die Baugruppe, z. B. eine PLA personalisiert wird. In diesem Sinne kann eine Makro-Struktur eine von vielen speziellen logischen Funktionen ausführen, abhängig von ihrer gewünschten Personalisierung.

Den Gegensatz zu den als Makro-Strukturen bezeichneten Gruppen von Schaltungselementen zur Ausführung einer bestimmten logischen Funktion bilden die Grundverknüpfungsglieder, aus denen eine zur Ausführung einer logischen Funktion geeignete Makrostruktur gebildet werden kann. In diesem Sinn kann eine PLA als eine aus Grundverknüpfungsgliedern aufgebaute Makro-Struktur angesehen werden. Daher sind PLA stets prüfbar im Sinne der Grundverknüpfungsglieder, da eine PLA durch Grundverknüpfungsglieder nachgebildet werden kann, für die Prüfgeneratoren Prüfmuster erzeugen können. Wenn jedoch die Dichte zunimmt, was sich in einer zunehmenden Anzahl von Grundverknüpfungsgliedern in dem Modell widerspiegelt, wird mehr Computerleistung für die Prüfmustererzeugung und das Nachbilden benötigt.

Ein Problem, das bei Versuchen nach dem Stand der Technik auftrat, PLA nachzubilden, besteht darin, daß, wenn man große Teile eines kombinatorischen logischen Netzwerkes in PLA unterteilt, dies dann im allgemeinen dazu führt, daß ein PLA ein anderes speist. Dies liegt daran, daß ein PLA eine bestimmte logische Funktion ausführt. In einem PLA kann man mehrere logische Eingangssignale in einer sehr wirksamen Weise konzentrieren, um ein oder zwei Ausgangssignale zu erzeugen, die auf diesen logischen Eingangssignalen basieren. Die Ausgänge können als Steuerleitungen für ein zweites PLA benutzt werden für Kanal- oder andere Funktionen. Durch Reihenschaltungen der PLA gewinnt man den Nutzeffekt, daß die ersten und zweiten PLA sehr wirksam personalisiert werden. Jedoch sind PLA nicht zweckmäßig unterteilbar, so daß sie nach Art von Makro-Strukturen geprüft werden können.

Anders ausgedrückt können PLA parallel implementiert werden, aber dies ist so, als habe man nur eine einzige PLA. In diesem Fall wird die PLA weniger wirksam personalisiert und beträchtlicher Platz kann verloren gehen. Daher war die naheliegende Lösung nach dem Stand der Technik, daß ein PLA ein anderes speiste, um eine sehr wirksame Personalisierung beizubehalten, und die resultierende Struktur in Form von Grundverknüpfungsgliedern zum Zweck der Prüfmustererzeugung nachzubilden.

Wenn man eine PLA als eine Makro-Struktur zu prüfen wünscht, dann ist es im allgemeinen nicht möglich, ein Makro-Prüfmuster für die erste PLA so zu erzeugen, daß das aus dem Prüfmuster resultierende Ausgangssignal unverzerrt die zweite PLA durchläuft.

Dies liegt daran, daß es eine Eigenart jeder PLA ist, daß ihre kombinatorische Logik im allgemeinen nichtlinear ist und als eine Folge hiervon im allgemeinen einige Prüfmuster für die zweite PLA die erste PLA nicht in unverzerrter Weise durchlaufen können. Daher können Muster für Kombinationen von PLA für beide PLA nur erzeugt werden, wenn die gesamte Logik für Zwecke der Prüfmustererzeugung durch Grundverknüpfungsglieder (UND, ODER, NAND, NOR) nachgebildet ist. Wie bereits früher erwähnt, erfordert dies wegen der großen Anzahl von Grundverknüpfungsgliedern, die in dem Nachbildungsprozeß benutzt werden, viel Rechenleistung. Außerdem wird der Rechenprozeß durch viele Eingangs- und Ausgangsverzweigungen kompliziert.

Es wurde bereits erkannt, daß Forderungen bezüglich der Prüfmustererzeugung vernünftige Beschränkungen für den logischen Entwurf auferlegen können, um das Prüfen zu erleichtern. Es wurden jedoch nicht erkannt, inwieweit einige dieser Entwurfsbeschränkungen andere sein könnten als Beschränkungen für die Grundverknüpfungsglieder.

Die Erfindung, wie sie in den Ansprüchen gekennzeichnet ist, löst die Aufgabe, die Prüfbarkeit eines Halbleiterplättchens mit monolithisch hochintegrierten Schaltungen zu verbessern, das eingebettete, d. h. von den Eingangs- und Ausgangsanschlüssen des Halbleiterplättchens direkt nicht zugängliche programmierbare logische Anordnungen (PLA) sowie lineare logische Funktionen realisierende Schaltungen und Schieberegister enthält.

Die Architektur des Halbleiterplättchens wird so ausgelegt, daß sie aus mehreren PLA und Übertragungswegen als kombinatorische Logik besteht, wobei die PLA in der Weise verbunden sind, daß nur die Übertragungswege mit den Ausgängen einer oder mehrerer PLA in Reihe geschaltet werden. Die PLA erscheinen für das Prüfen in einer gegenseitigen parallelen Konfiguration durch Einschluß von Verriegelungsschaltungen, die keine logische Funktion ausführen, aber gelegentlich für Prüfzwecke benutzt werden können. Solche Verriegelungsschaltungen führen lediglich eine Durchgangsfunktion aus, d. h. eine Verzögerung. Außerdem sind für die PLA keine wiederzusammenlaufenden Ausgangsverzweigungen erlaubt, d. h. wo die Eingänge gemeinsam sind, sind die Ausgänge gegenseitig ausschließend, beispielsweise wenn die Eingänge miteinander verbunden sind, sind es die Ausgänge nicht, oder wenn die Ausgänge miteinander verbunden sind, sind es die Eingänge nicht.

Andere Anordnungen sind Strukturen zur Realisierung linearer logischer Funktionen anstelle von Übertragungswegen, wie z. B. Antivalenz-Glieder, Decodierer oder Codeumsetzer für das Schalten der Übertragungswege zwischen dem PLA und dem Ausgang.

Für Zwecke dieser Erfindung bedeutet der Ausdruck linear, daß die Ausgangsantwort eine 1 : 1 Abbildung der Eingangsmuster ist, d. h. für jedes eindeutige Eingangsmuster gibt es ein eindeutiges Ausgangsmuster. Wenn beispielsweise zwei Eingangsmuster wie:

```
1  0
1  1
1  0
```

zwei Ausgangsmuster liefern wie z. B.:

```
1  0
0  0
1  1
```

dann sind die Eingangsmuster eindeutig in die Ausgangsmuster abgebildet. Wenn jedoch die beiden Eingangsmuster die folgenden sind:

```
0  1
1  0
0  0
```

und die entsprechenden Ausgangsmuster die folgenden:

```
0  0
0  0
0  0
```

dann sind die Eingangsmuster nicht eindeutig in die Ausgangsmuster abgebildet, da die beiden Ausgangsmuster die gleichen für zwei verschiedene Eingangsmuster sind und daher nicht die Eindeutigkeitseigenschaften der Eingangsmuster beibehalten.

Es sei jedoch bemerkt, daß ein Übertragungsweg nicht im wesentlichen linear ist, aber daß seine Nichtlinearität von solcher Art ist, daß sie gesteuert werden kann ähnlich den linearen Einrichtungen, da der Übertragungsweg ein Ein-Aus-Schalter ist, denn wenn der Übertragungsweg eingeschaltet ist, führt er eine lineare Signalweitergabe-Funktion durch und wenn er ausgeschaltet ist, blockiert er die Signalwege. Daher können die Prüfmuster für Übertragungswege erzeugt werden und bereiten keine Schwierigkeiten wie das andere nichtlineare Einrichtungen tun. Bei eingeschaltetem Übertragungsweg breiten sich die PLA-Muster in ihm aus, wobei die 1 : 1 Abbildung erhalten bleibt. Da außerdem die Übertragungswege eine einfache logische Struktur darstellen, können die Antworten auf die Prüfmuster der PLA, die an deren Ausgang erscheinen, als Prüfmuster für den Übertragungsweg benutzt werden. Der Vorteil der Kombination des Schaltens von Übertragungswegen mit PLA besteht darin, daß Prüfmuster für die PLA erzeugt werden können, die gleichzeitig auch das Prüfen der Übertragungswege durchführen können.

Im folgenden wird die Erfindung anhand der Zeichnungen näher beschrieben, von denen zeigt

Fig. 1 die Organisation einer typischen Logikkonfiguration zur Prüfung von PLA nach dem Grundgedanken der Erfindung;

Fig. 2 eine Schaltung mit PLA und Übertragungswegen, die so angeordnet sind, daß sie als

3

Makro-Struktur prüfbar sind:

Fig. 3 die Struktur eines typischen Zählers;

Fig. 4 die Struktur eines typischen Addierwerks und

Fig. 5 die Datenpfadstruktur der Schaltung nach Fig. 2.

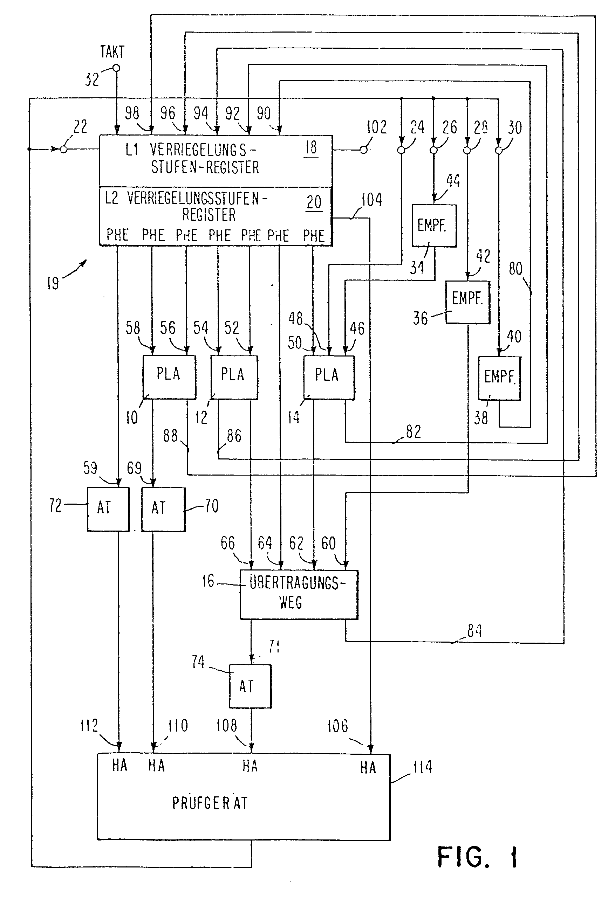

Fig. 1 zeigt eine typische Konfiguration eines Logikentwurfs gemäß der Erfindung im Prüfbetrieb im Gegensatz zu dem Normalbetrieb, in dem logische Funktionen ausgeführt werden. Die Logik ist in der Weise aufgebaut, daß bei Anlegen eines Steuersignals sie in den Prüfbetrieb versetzt wird, in dem alle Verriegelungsschaltungen miteinander verbunden sind, um als ein Schieberegister zu arbeiten. Dadurch wird die kombinatorische Logik mit PLA strukturiert. Für einen wirkungsvollen Betrieb werden in vielen Fällen die PLA in Reihe geschaltet, was es unpraktisch macht, sie im Sinn einer Makro-Struktur zu prüfen. In diesen Situationen werden Verriegelungsschaltungen, die keine logische Funktion haben, zwischen die PLA gesetzt. Im Prüfbetrieb werden diese Verriegelungsschaltungen Stufen eines Schieberegisters. Es sei bemerkt, daß Verriegelungsschaltungen nicht zwischen PLA und anderer Logik eingeschlossen zu sein brauchen, bei der es sich entweder um einen Übertragungsweg oder um eine lineare logische Einrichtung handelt, da die erwarteten Antworten die lineare Logik auf der Basis auf einer 1 : 1 Abbildung durchlaufen, um so die PLA zu prüfen. Bei dem dargestellten Prüfbetrieb sind 3 PLA 10, 12 und 14 parallel angeordnet und in ein hochintegriertes Halbleiterplättchen eingebettet. Obgleich 3 PLA dargestellt sind, ist die Erfindung ebenso anwendbar auf 2 oder auf eine größere Anzahl als 3 PLA. Auch ein Datenübertragungsweg 16 ist vorgesehen. Im allgemeinen Fall kann eine Reihe von Datenwegen benutzt werden.

Um die PLA 10, 12 und 14 sowie den Datenübertragungsweg 16 im Sinne einer Makro-Struktur zu prüfen ist ein Schieberegister 19 dargestellt, das in zwei getrennte Sätze von Verriegelungsstufen 18 und 20 unterteilt ist. Der Übertragungsweg 16 besteht aus einem Satz von UND-Gliedern. Wenn ein Prüfmuster die Register-Verriegelungsschaltungen 18 füllt, wird deren Inhalt parallel in die L2-Verriegelungsschaltungen 20 durch einen am Anschluß 32 auftretenden Taktimpuls übertragen. Durch Vorsehen einer Taktgeberschaltung für die L1-Verriegelungsschaltungen 18 und die L2-Verriegelungsschaltungen 20 wird das unterschiedlich schnelle Durchlaufen des Musters durch die Logik, die aus den PLA 10, 12 und 14 besteht sowie dem Übertragungsweg 16 und den L1-Verriegelungsschaltungen 18, unschädlich gemacht, da die Muster ihren stationären Zustand erreichen müssen, bevor sie in L2-Verriegelungsschaltungen 20 aufgrund eines Taktimpulses übertragen werden. Um die PLA zu prüfen, wird ein in dem Prüfgerät 114 gespeichertes Prüfmuster seriell in die Verriegelungsschaltungen 18 über den Eingabeanschluß 22 eingegeben.

Gleichzeitig mit dem taktgesteuerten Übertragen des Prüfmusters aus den L1-Verriegelungsschaltungen 18 in die L2-Verriegelungsschaltungen 20 wird ein anderer Teil des Prüfmusters, das in dem Prüfgerät 114 gespeichert ist, parallel den Anschlüssen 24, 26, 28 und 30 zugeführt, wobei das Eingangssignal am Anschluß 24 der PLA 14 über den Anschluß 48 zugeführt wird, das Eingangssignal am Anschluß 26 dem Empfänger 34 über den Anschluß 44 zugeleitet wird und dann der PLA 14 über den Anschluß 46, während das Eingangssignal am Anschluß 28 dem Empfänger 36 über den Anschluß 42 und dem Datenübertragungsweg 16 über den Anschluß 60 zugeführt wird, während das Eingangssignal am Anschluß 30 dem Empfänger 38 über den Anschluß 40 zugeführt wird. Über den Anschluß 90 ist der Empfänger 38 auf die L1-Verriegelungsschaltungen 18 rückgekoppelt. Das in dem L2-Verriegelungsschaltungen 20 enthaltene Prüfmuster liefert Eingangssignale an die Pseudo-Hauptanschlußklemmen 50, 52, 54, 56, 58, 59 und 64. Das Muster an den Anschlüssen 46, 48 und 50 durchläuft die PLA 14 und liefert ein Ausgangssignal auf der Leitung 82, das als ein Pseudo-Hauptausgangssignal über den Anschluß 92 auf eine der L1-Verriegelungsschaltungen 18 rückgekoppelt wird. In ähnlicher Weise gelangt das Muster über die Anschlüsse 60, 62, 64 und 66 in den Datenübertragungsweg 16, den es durchläuft und ein Ausgangssignal auf der Leitung 84 liefert, das als Pseudo-Hauptausgangssignal über den Anschluß 94 in eine der Verriegelungsschaltungen 18 rückgekoppelt wird. In ähnlicher Weise gelangen die Signale an den Pseudo-Hauptanschlüssen 52 und 54 in die PLA 12, die ein Pseudo-Hauptausgangssignal auf der Leitung 86 liefert, das über den Anschluß 96 in eine der L1-Verriegelungsschaltungen 18 rückgekoppelt wird. Die Antwort der PLA 10 wird über die Hauptausgangsleitung 88 und den Anschluß 98 zu einer der L1-Verriegelungsschaltungen 18 rückgekoppelt. Nachdem die Prüfmuster die PLA 10, 12 und 14 sowie den Übertragungsweg 16 durchlaufen und Antworten erzeugt haben, die in den L1-Verriegelungsschaltungen 18 gespeichert wurden, wird dem Anschluß 102 ein Taktimpuls zugeführt, um die Ergebnisse taktgesteuert auf die Leitung 104 zu übertragen und über den Anschluß 106 dem Prüfgerät 114 zuzuführen, dessen Einzelheiten bekannt sind und keinen Teil der Erfindung bilden. Jeder Satz von Antwortmustern an den Pseudo-Hauptanschlüssen gelangt in das Prüfgerät 114, in dem diese Sätze für Vergleichszwecke mit einer erwarteten Antwort gespeichert werden. Ausgangstreiberstufen 70, 72 und 74 empfangen die Hauptausgangssignale des Datenübertragungsweges 16, der PLA 10 und der L2-Verriegelungsschaltungen 20 über die Anschlüsse 69, 59 und 71. Die Ausgangssignale dieser Ausgangstreiberstufen gelangen über die Anschlüsse 108, 110 und 112 zusammen mit dem Prüfmuster in das Prüfgerät 114. Es ist daher ersichtlich, daß das Prüfmuster, das den Eingangsanschlüssen 22, 24, 26, 28 und 30 zugeführt wurde, die kombinatorische Logik, einschließlich der parallelen PLA und der Einrichtungen zur Durchführung linearer logischer Funktionen durchläuft, um die Prüfung durchzuführen und ein

4

Ausgangsmuster zu erzeugen, das auf die Leitung 104 ausgeschoben und dem Testgerät 114 zusammen mit den anderen Ausgangssignalen an den Anschlüssen 108, 110 und 112 zugeführt wird, so daß ein Vergleich durchgeführt werden kann. Wenn die ausgeschobenen Signale mit den erwarteten übereinstimmen, dann liegen keine Fehler vor, die mit diesem speziellen Prüfmuster festgestellt werden können.

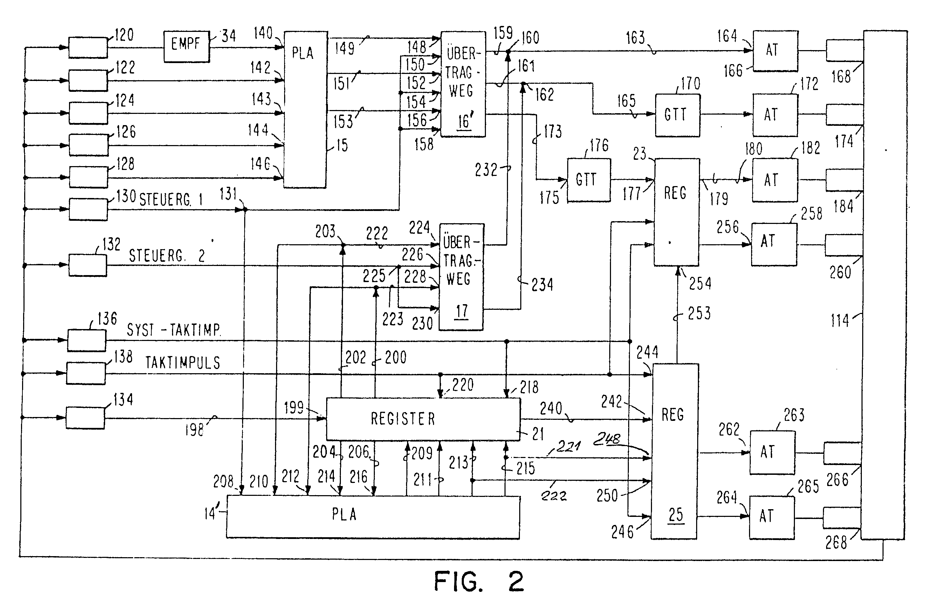

Fig. 2 zeigt ein bevorzugtes Ausführungsbeispiel gemäß der Erfindung. Das Schaltbild nach Fig. 2 ist nicht nur detaillierter als das nach Fig. 1, sondern es sind die Komponenten auch unterschiedlich angeordnet. Beispielsweise sind zwei PLA, 14' und 15 in Fig. 2 dargestellt, wogegen 3 PLA 10, 12 und 14 in Fig. 1 gezeigt sind. Es entsprechen sich nur die PLA 14 und die PLA 14' in beiden Figuren. Ebenso sind zwei Übertragungswege 16' und 17 in Fig. 2 dargestellt, wogegen nur ein Übertragungsweg 16 in der Fig. 1 gezeigt ist, aber die Übertragungswege 16 und 16' in beiden Figuren im wesentlichen die gleichen sind. Es ist daher ersichtlich, daß die kombinatorische Logik die nach Fig. 2 geprüft wird, aus den beiden PLA 14' und 15, den Übertragungswegen 16' und 17, dem Empfänger 34, den Gegentakt-Treiberstufen 170 und 176, den Registern 21, 23 und 25 sowie den Ausgangs-Treiberstufen 166, 172, 182, 258, 263 und 265 besteht. Es sei bemerkt, daß die Register 21, 23 und 25 Verriegelungsschaltungen enthalten, die so miteinander verbunden sind, daß sie Schieberegister bilden.

Um die PLA 15 zu prüfen, empfangen die Eingangsanschlüsse 120, 122, 124, 126 und 128 das vom Prüfgerät 114 gelieferte Prüfmuster parallel. Während der Eingangsanschluß 120 mit einem Empfänger 34 verbunden ist, dessen Ausgang an den Anschluß 140 der PLA 15 angeschlossen ist, sind die restlichen Eingangsanschlüsse 122, 124, 126 und 128 direkt mit den Eingangsanschlüssen 142, 143, 144 und 146 der PLA 15 verbunden.

Die drei Datenausgänge der PLA 15 sind über Leitungen 149, 151 und 153 mit den Anschlüssen 148, 152 und 156 des Übertragungsweges 16' verbunden. Das Eingangssignal am Anschluß 130 liefert ein Steuersignal an die Anschlüsse 150, 154 und 158, um dem Übertragungsweg die Durchführung einer UND-Funktion zu ermöglichen und ein Ausgangssignal der Leitung 159, dem Verbindungspunkt 160 und der Leitung 163 zuzuführen, um über den Anschluß 164 ein Signal der Ausgangs-Treiberschaltung 166 zuzuführen, die ein Ausgangssignal am Ausgangsanschluß 168 erzeugt, der mit dem Prüfgerät 114 verbunden ist. Die Verbindung zweier Leitungen miteinander entspricht der Durchführung einer ODER-Verknüpfung. Auch das einer UND-Verknüpfung unterworfene Eingangssignal am Anschluß 152 durchläuft den Übertragungsweg 16', um ein Ausgangssignal auf den Leitungen 161 und 165 zu erzeugen, das die Gegentakttreiberschaltung 170 durchläuft, um der Ausgangs-Treiberschaltung 172 ein Eingangssignal zuzuführen, die wiederum ein Ausgangssignal am Ausgangsanschluß 174 erzeugt, das dem Prüfgerät 114 zugeführt wird. In ähnlicher Weise sorgt das Steuereingangssignal am Anschluß 158 dafür, daß das dem Anschluß 156 zugeführte Eingangssignal den Übertragungsweg 16' durchläuft, um ein Ausgangssignal auf der Leitung 173 zu erzeugen, das dem Anschluß 175 der Gegentakt-Treiberschaltung 176 zugeführt wird. Diese wiederum erzeugt ein Eingangssignal für den Anschluß 177 des Registers 23, das wiederum unter noch zu erläuterten Bedingungen ein Datenausgangssignal auf der Leitung 180 erzeugt, das der Ausgangs-Treiberschaltung 182 zugeführt wird, die am Ausgangsanschluß 184 ein Signal liefert, das der Prüfeinrichtung 114 zugeführt wird.

In diesem bevorzugten Ausführungsbeispiel arbeiten das Register 21 und die PLA 14' parallel. Der Eingangsanschluß 134 ermöglicht es, das für die PLA 14' auf der Leitung 198 erzeugte Prüfmuster seriell dem Register 21 über dessen Eingangsanschluß 199 zuzuführen. Es sei bemerkt, daß das Prüfmuster für die PLA 14' nicht nur diese PLA prüft, sondern auch das Eingangsprüfmuster für den Übertragungsweg 17 darstellt. Wenn daher das Prüfmuster das Register 21 füllt, liefert der Taktgeber dem Eingangsanschluß 138 einen Taktimpuls, um ein Ausgangssignal, das dem Inhalt des Registers 21 entspricht, auf den Leitungen 200, 202, 204 und 206 zu erzeugen. Es sei bemerkt, daß die Ausgangssignale auf den Leitungen 200 und 202 auch dem Übertragungsweg 17 als Eingangssignale über die Leitungen 222 und 223 zugeführt werden. Wenn daher ein Steuersignal am Eingangsanschluß 132 auftritt, werden die Signale an den Anschlüssen 224 und 226 einer UND-Verknüpfung unterworfen, um ein Ausgangssignal auf der Leitung 232 zu erzeugen, das auch zum Verbindungspunkt 160 gelangt. In ähnlicher Weise erzeugt das dem Eingangsanschluß 132 zugeführte Steuersignal ein Signal am Anschluß 230, das mit dem Signal am Anschluß 228 einer UND-Verknüpfung unterworfen wird, um ein Ausgangssignal auf der Leitung 234 zu erzeugen, das auch zum Verbindungspunkt 162 gelangt. Wie noch erklärt wird, bestimmt der Binärwert (0 oder 1) an den Anschlüssen 130 und 132, welcher von ihnen den steuernden Wert aufweist, um dadurch zu bestimmen, ob die Information aus dem Register 21 oder die aus der PLA 15 den Verbindungspunkten 160 und 162 zugeführt wird. Da die Übertragungswege 16' und 17 eine NOR-Funktion ausführen, wenn das Eingangssignal für den Anschluß 130 eine binäre Eins und das Eingangssignal für den Anschluß 132 eine binäre Null ist, wird der Übertragungsweg 16' gesperrt und sein Ausgangssignal ist eine Null, und der Übertragungsweg 17 wird freigegeben, so daß die Signale auf den Leitungen 232 und 234 über die Verbindungspunkte 160 und 162 auf die Leitungen 163 und 165 und weiter über die Anschlüsse 168 und 174 zum Prüfgerät 114 gelangen. Wenn andererseits das Signal am Anschluß 130 eine binäre Null ist und das am Eingangsanschluß 132 eine binäre Eins, wird der Übertragungsweg 17 blockiert und der Übertragungsweg 16' wird freigegeben und die Information gelangt auf die Leitungen 159 und 161 und über die Verbindungspunkte 160 und 162 und die Anschlüsse 168 und 174 zu dem Prüfgerät 114.

Gleichzeitig mit dem Prüfen des Übertragungsweges 17 gelangen die Prüfmuster auf den Leitungen 200, 202, 204 und 206 zu den Anschlüssen 208, 210, 212, 214 und 216 der PLA 14'. Das Prüfmuster durchläuft die PLA 14' und erzeugt auf den Leitungen 209, 211, 213 und 215 eine Antwort zur Weiterleitung in das Register 21 bei Eintreffen eines System-Taktimpulses am Eingangsanschluß 136, welcher System-Taktimpuls dem Anschluß 218 des Registers 21 zugeführt wird. Über Taktimpulse am Anschluß 138 wird der Registerinhalt auf die Leitung 240 ausgegeben, um über den Anschluß 242 dem Register 25 zugeführt zu werden. Zur Ausgabe der im Register 21 gespeicherten Antwort werden Taktimpulse den Anschlüssen 138 und 136 zugeführt. Hierdurch gelangt das Muster über die Leitung 240 durch das Register 25 und dann über die Leitung 253 und das Register 23 auf dessen Ausgangsleitung 180 und über die Ausgangs-Treiberschaltung 182 und dem Ausgangsanschluß 184 in das Prüfgerät 114.

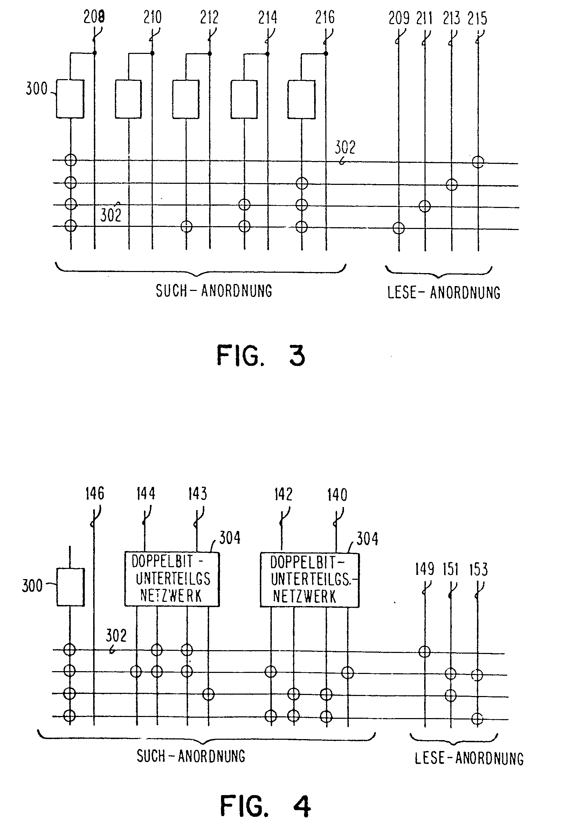

Bei der Erzeugung eines Prüfmusters für die spezielle Schaltungsanordnung nach Fig. 2 besteht der erste Schritt darin, die Personalisierung der PLA zu benutzen, die deren logische Funktion beschreibt. Die Prüfmuster für die Makrostrukturen von PLA werden abgeleitet von der Personalisierung der PLA. In diesem Beispiel ist die Personalisierung für die PLA 14' nach Fig. 3 die eines Zählers, der aus NOR-Verknüpfungsgliedern aufgebaut ist.

Die Eingänge der PLA sind mit 208, 210, 212, 214 und 216 bezeichnet. Die Ausgänge sind mit 209, 211, 213 und 215 bezeichnet. Jede Eingangsleitung in Fig. 3 ist in zwei Leitungen aufgespalten, von dem eine mit einem Inverter 300 verbunden ist. Die PLA 14' besitzt vier Wortleitungen 302. Die Personalisierung der PLA 14' wird geschaffen durch Anordnen eines Feldeffekttransistors an ausgewählten, durch einen Kreis bezeichneten Kreuzungspunkten. ,

Die Personalisierung der PLA 15 ist die eines Addierwerks, das in Fig. 4 dargestellt ist und aus NOR-Verknüpfungsgliedern besteht, und dessen Eingänge mit 140, 142, 143, 144 und 146 bezeichnet sind. Die Ausgänge sind als 149, 151 und 153 bezeichnet. Je zwei Eingangsleitungen sind in einem Doppelbit-Unterteilungsnetzwerk 304 zusammengefaßt. Die unterteilten Bitleitungen, die von dem Doppelbit-Unterteilungsnetzwerk in die PLA gelangen, werden an für die Personalisierung ausgewählten Kreuzungspunkten durch Feldeffekttransistoren mit den Wortleitungen 302 verbunden, was durch Kreise angedeutet ist. Diese verbundenen Kreuzungspunkte repräsentieren die Personalisierung für die PLA 15. .

Unter Benutzung der Personalisierungen für die PLA 14' und 15 werden die Prüfmuster in den folgenden Tabellen I und II abgeleitet. Das Ableiten der Prüfmuster ist bekannt und bildet keinen Teil der Erfindung. Wie schon erwähnt und den Fig. 3 und 4 zu entnehmen ist, bestehen (a) sowohl die Such-Anordnung als auch die Lese-Anordnung aus NOR-Verknüpfungsgliedern, sind (b) am Ausgang der PLA 14' Inverter als integraler Teil der PLA 14' vorgesehen und weist (c) der Ausgang der PLA 15 keine Inverter auf. .

Tabelle I

Muster-Satz für PLA 14'

| 2 | 2 | 2 | 2 | 2 | | 2 | 2 | 2 | 2 |
| 0 | 1 | 1 | 1 | 1 | | 0 | 1 | 1 | 1 |
| 8 | 0 | 2 | 4 | 6 | | 9 | 1 | 3 | 5 |
| | | | | | | | | | |
| 1 | — | 1 | 1 | 1 | | 1 | 1 | 1 | 1 |
| 0 | — | 1 | 1 | 1 | | 0 | 0 | 0 | 0 |
| 1 | — | 1 | 1 | 0 | | 1 | 0 | 0 | 0 |
| 1 | — | 1 | 0 | 1 | | 1 | 1 | 0 | 0 |
| 1 | — | 0 | 1 | 1 | | 1 | 1 | 1 | 0 |

Muster                Erwartete Antwort

Anmerkung: Der Wert für den Eingang 210 kann willkürlich gewählt werden.

6

Tabelle II

Muster-Satz für PLA 15

| 1 | 1 | 1 | 1 | 1 | | 1 | 1 | 1 |
|---|---|---|---|---|---|---|---|---|
| 4 | 4 | 4 | 4 | 4 | | 4 | 5 | 5 |
| 6 | 4 | 3 | 2 | 0 | | 9 | 1 | 3 |
| | | | | | | | | |
| 1 | 1 | 1 | 0 | 0 | | 0 | 1 | 1 |
| 1 | 1 | 1 | 1 | 1 | | 0 | 1 | 0 |
| 1 | 0 | 0 | 1 | 0 | | 0 | 1 | 1 |
| 1 | 1 | 0 | 0 | 1 | | 1 | 1 | 1 |
| 1 | 1 | 1 | 1 | 0 | | 0 | 0 | 0 |
| 1 | 0 | 1 | 1 | 0 | | 1 | 1 | 1 |
| 1 | 1 | 0 | 0 | 0 | | 1 | 0 | 1 |
| 1 | 0 | 1 | 1 | 1 | | 1 | 0 | 0 |
| 1 | 1 | 1 | 0 | 1 | | 0 | 0 | 0*) |
| 0 | 0 | 0 | 1 | 1 | | 1 | 1 | 1*) |

Muster              Erwartete Antwort

*) Es ist eine willkürliche Auswahl beim Aussuchen dieser Muster einbegriffen.

Tabelle III

| | Prüfmuster für die PLA 15 und 14' enthaltende Unterteilung | | | | | | | | | | | | | | | | | | | |
|---|---|---|---|---|---|---|---|---|---|---|---|---|---|---|---|---|---|---|---|---|
| | 1 | 2 | 3 | 4 | 5 | 6 | 7 | 8 | 9 | 10 | 11 | 12 | 13 | 14 | 15 | 16 | 17 | 18 | 19 | 20 |
| PLA 15 Eingangsmuster | | | | | | | | | | | | | | | | | | | | |
| Anschluß 128 | 1 | 1 | 1 | 1 | 1 | 1 | 1 | 1 | 1 | 0 | 0 | 0 | | | | | | | | |
| Anschluß 126 | 1 | 1 | 0 | 1 | 1 | 0 | 1 | 0 | 1 | 0 | 1 | 1 | | | | | | | | |
| Anschluß 124 | 1 | 1 | 0 | 0 | 1 | 1 | 0 | 1 | 1 | 0 | 1 | 1 | | | | | | | | |
| Anschluß 122 | 0 | 1 | 1 | 0 | 1 | 1 | 0 | 1 | 0 | 1 | 0 | 0 | | | | | | | | |
| Anschluß 120 | 0 | 1 | 0 | 1 | 0 | 0 | 0 | 1 | 1 | 1 | 1 | 1 | | | | | | | | |
| Anschluß 132 | 1 | 1 | 1 | 1 | 1 | 1 | 1 | 1 | 1 | 1 | 1 | 1 | 0 | 0 | 0 | 0 | 0 | 0 | 0 | 1 |
| Anschluß 130 | 0 | 0 | 0 | 0 | 0 | 0 | 0 | 0 | 0 | 0 | 0 | 0 | 1 | 0 | 1 | 1 | 1 | 1 | 1 | 1 |
| PLA 14' Eingangsmuster | | | | | | | | | | | | | | | | | | | | |
| | | | | | | | | | | | | | 1 | 1 | 1 | 1 | 0 | | | |
| Anschluß 134 | | | | | | | | | | | | | 1 | 1 | 1 | 0 | 1 | 0 | 1 | 0 |
| | | | | | | | | | | | | | 1 | 1 | 0 | 1 | 1 | 1 | 0 | 0 |

0 010 173

Fortsetzung

0 0 1 0 1 7 3

Prüfmuster für die PLA 15 und 14′ enthaltende Unterteilung

| | 1 | 2 | 3 | 4 | 5 | 6 | 7 | 8 | 9 | 10 | 11 | 12 | | 13. | 14 | 15 | 16 | 17 | 18 | 19 | | 20 |
|---|---|---|---|---|---|---|---|---|---|---|---|---|---|---|---|---|---|---|---|---|---|---|
| **PLA 15 erwartetes Ausgangsmuster** | | | | | | | | | | | | | | | | | | | | | | |
| Anschluß 168 | 0 | 0 | 0 | 1 | 0 | 1 | 1 | 1 | 0 | 1 | 1 | 0 | | | | | | | | | | |
| Anschluß 174 | 1 | 1 | 1 | 1 | 0 | 1 | 0 | 0 | 0 | 1 | 1 | 0 | | | | | | | | | | |
| Anschluß 260 | 1 | 0 | 1 | 1 | 0 | 1 | 1 | 0 | 0 | 1 | 1 | 0 | | | | | | | | | | |
| | | | | | | | | | | | | | | **PLA 14′ erwartetes Ausgangsmuster** | | | | | | | | |
| Anschluß 266 | | | | | | | | | | | | | | 1 | 0 | 1 | 1 | 1 | | | | |
| | | | | | | | | | | | | | | 1 | 0 | 0 | 1 | 1 | | | | |

Prüfung der PLA 15 und des Übertragungsweges 16 — Prüf. d. Übertr.-weges 16 auf S-0 — Prüfung d. PLA 14 — Prüf. d. Übertr.-weges 17 — Prüf. d. Übertr.-weges 17 auf S-0

Nachdem die Prüfmuster für die PLA erzeugt wurden, werden sie zusammengestellt, um die Grundlage für die Fehlerbestimmung zu liefern. Für die Zwecke der Erfindung wird ein Prüfmuster definiert als ein Satz von Einsen und Nullen, die zu einem bestimmten Zeitpunkt als Erregung allen Haupteingängen (HE) und Pseudo-Haupteingängen (PHE) zugeführt werden. Entsprechend jedem Prüfmuster gibt es ein erwartetes Antwortmuster, das zu einem bestimmten Zeitpunkt an allen Pseudo-Hauptausgängen (PHA) und Hauptausgängen (HA) für Vergleichszwecke in dem Prüfgerät 114 abgetastet wird.

Wie oben bemerkt, beginnt die Prüfung mit den in den Tabellen I und II angegebenen Prüfmuster, während die Prüfmuster für die betrachtete Unterteilung in Tabelle III angegeben sind.

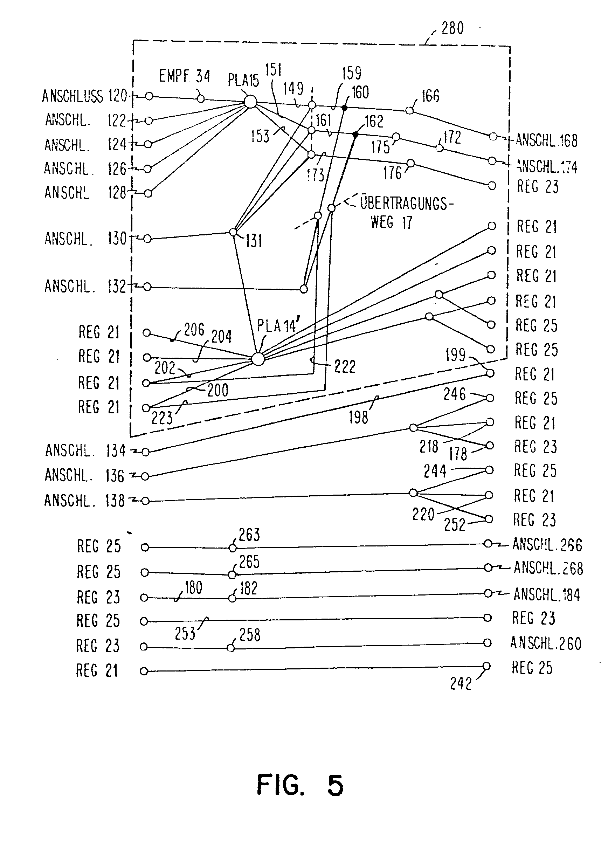

Fig. 5 zeigt ein Diagramm der Daten- und Steuersignalpfade für die Schaltung nach Fig. 2. Die linke Seite der Figur zeigt als Haupteingänge die Anschlüsse 120, 122, 124, 126, 128, 130, 132, 134, 136 und 138 sowie Pseudo-Haupteingänge für die Leitungen 200, 202, 204 und 206. Die Pseudo-Haupteingänge gehen von den Registern 21, 23 und 25 aus. Diese Pseudo-Haupteingänge vom Register 21 sind an die Leitungen 200, 202, 204, 206, 222 und 223 angeschlossen. Die Pseudo-Haupteingänge vom Register 23 sind mit der Leitung 180 und den Ausgangs-Treiberschaltungen 182 und 258 verbunden. Die Pseudo-Haupteingänge vom Register 25 sind mit der Leitung 253 und den Ausgangs-Treiberschaltungen 263 und 265 verbunden. Die rechte Seite der Figur zeigt als Hauptausgänge die Anschlüsse 168, 174, 184, 260, 266 und 268 sowie die Pseudo-Hauptausgänge 199, 246, 218, 178, 244, 220 und 252.

Es ist wichtig, daß die PLA so verbunden werden, daß keine wiederzusammenlaufenden Ausgangsverzweigungen auftreten. Zur Erläuterung sei gesagt, daß ein Zusammenlaufen dann gegeben ist, wenn mehrere Eingänge zu einem Knoten führen. Beispielsweise führen in Fig. 5 die Eingangsanschlüsse 120, 122, 124, 126 und 128 zu der PLA 15. Eine Ausgangsverzweigung ist dann gegeben, wenn von einem Knoten eine Reihe von Ausgängen ausgehen. Ein Beispiel ist der mit dem Steuersignalanschluß 130 verbundene Knoten 131, der sich ausgangsseitig verzweigt in drei Eingänge für den Übertragungsweg 16' und einen für die PLA 14'.

Daß die Ausgangsverzweigungen nicht wiederzusammenlaufen ist deshalb wichtig, um die PLA gegenseitig parallel und sich nicht störend (in einer Prüfanordnung) anzuordnen. Wenn die Ausgangsverzweigungen wiederzusammenlaufen würden, wie das nach dem Stand der Technik der Fall ist, können sich die Prüfmuster stören und die Prüfergebnisse unverständlich werden. Wie zu Beginn der Beschreibung der Erfindung ausgeführt wurde, ist das nicht Wiederzusammenlaufen eine Beschränkung, die für PLA erforderlich ist, damit sie wirksam geprüft werden können.

In der Tabelle III sind die Prüfmuster für die die PLA 14' und 15 enthaltende Unterteilung dargestellt. Als Unterteilung wird eine Teilschaltung bezeichnet, bei der die Datenleitungen so verbunden sind wie das in Fig. 5 in dem von der Strichlinie 280 umgebenen Teil der Fall ist. Prüfmuster für die PLA 15 sind in den Spalten 1—11 in Tabelle III dargestellt und werden nacheinander angelegt. Beispielsweise wird das in Spalte 1 dargestellte Muster für die PLA 15 den Eingangsanschlüssen 120—128 der Fig. 2 zugeführt. Das erwartete Ausgangsmuster sollte nach Spalte 1 der Tabelle III 011 sein. Das Prüfmuster für die PLA 14' ist in den Spalten 13—17 gezeigt. Das Prüfmuster nach Spalte 13 wird dem Eingangsanschluß 134 zugeführt, um seriell dem Register 21 zugeleitet zu werden, wie das hinsichtlich des Registers 19 nach Fig. 1 über den Eingabeanschluß 22 erfolgte. Das erwartete Ausgangsmuster sollte 11 sein, wie das der Spalte 13 der Tabelle III zu entnehmen ist. Die Schaltung nach Fig. 2 erfaßt die meisten parallelen PLA Situationen wie serielles Eingeben der Ausgangssignale der PLA 15 in den Übertragungsweg 16' und paralleles Eingeben der Ausgangssignale der PLA 14' auf den Übertragungsweg 17, wobei die PLA gleichzeitig geprüft wird.

Wie aus Fig. 5 und der Tabelle III hervorgeht, können die Eingangssignale für die PLA 14' und 15 nicht parallel angelegt werden, obgleich keine wiederzusammenlaufende Ausgangsverzweigungen vorhanden sind, da die Eingaben in die PLA 14' und 15 unabhängig voneinander sind. Jedoch sorgt ein Steuersignal am Eingangsanschluß 130 für die Eingabe in die PLA 14' und die Steuerung des Übertragungsweges 16'. Wenn das Steuer-Eingangssignal die PLA 14' aktiviert, blockiert es den Übertragungsweg 16', um Störungen zu vermeiden. Wenn andererseits die PLA 14' blockiert ist, wird der Übertragungsweg 16' aktiviert und die Signale aus der PLA 15 können den Übertragungsweg 16' durchlaufen.

Zu Beginn einer Prüfoperation wird das Prüfmuster nach Spalte 1 der Tabelle III gleichzeitig den Eingangsanschlüssen 120, 122, 124, 126 und 128, die in den Fig. 2 und 5 dargestellt sind, zugeführt. Wie aus Fig. 2 zu ersehen ist, gelangen nur die den Anschlüssen 120, 122, 124, 126 und 128 zugeführten Eingangssignale in die PLA 15. Das Prüfmuster durchläuft die PLA 15 und führt in ihr die Prüfungen durch und liefert auf den Leitungen 149, 151 und 153 Ausgangssignale, die dem Übertragungsweg 16' zugeführt werden. Das Steuersignal am Eingangsanschluß 130 wird als Eingangssignal dem Übertragungsweg 16' zugeführt zur Durchführung einer UND-Verknüpfung der auf den Dateneingängen 148, 150 vorliegenden Daten, um ein Ausgangssignal am Verbindungspunkt 160 zu erzeugen, das wiederum zum Anschluß 164 der Ausgangs-Treiberschaltung 166 gelangt, die am Hauptausgang 168 ein Signal liefert, das für Vergleichszwecke dem Prüfgerät 114 zugeführt wird.

Die Steuer-Eingangssignale 152 und 154 werden zum Übertragungsweg 16' durchgeschaltet, um ein Ausgangssignal auf der Leitung 161 zu erzeugen, das zu dem Verbindungspunkt 162 gelangt und über die Gegentakt-Treiberschaltung 170 und die Ausgangs-Treiberschaltung 172 zum Anschluß 174, von wo es dem Prüfgerät zugeführt wird. Die den Eingangsanschlüssen 156 und 158 des Übertragungsweges 16' zugeführten Signale erzeugen nach ihrer Verknüpfung ein Ausgangssignal auf der Leitung 173, das über den Anschluß 177 der Gegentakt-Treiberschaltung 176 zugeführt wird, die ein Ausgangssignal erzeugt, das über den Anschluß 177 dem Register 23 zugeleitet wird.

Es sei bemerkt, daß das Muster in Spalte 1 der Tabelle III, das den Anschlüssen 120—128 der Fig. 2 zugeführt wird, ein erwartetes Antwortmuster erzeugen sollte, wie es in der Tabelle für die PLA 15 angegeben ist. Daher dient das Muster nach Spalte 1 der Prüfung der PLA 15 und des Übertragungsweges 16'. Wenn das erwartete Antwortmuster an den Anschlüssen 168, 174 und 184 erscheint, wie es für das Ausgangsmuster der PLA 15 gezeigt ist, dann hat dieses Muster keinen Fehler in der PLA 15 festgestellt. In ähnlicher Weise werden die restlichen Muster 2—11 der Schaltung nacheinander zugeführt. Wenn alle Antworten, die erwarteten sind, besitzt die PLA 15 keine Fehler.

Um zu prüfen, ob die Leitungen 150, 154 und 158, die die Steuerleitungen für den Übertragungsweg 16' bilden, ständig den Binärwert Eins aufweisen, wird dem Anschluß 130 ein 1-Signal zugeführt. Das Muster 000 in Spalte 12 der Tabelle III wird gewählt um die Leitungen 149, 151 und 153 zu prüfen. Dies ist die Prüfung darauf, ob die Steuerleitungen für den Übertragungsweg ständig den Binärwert Null aufweisen.

Die Ausgangssignale an den Anschlüssen 168 und 174 kommen gleichzeitig an und werden dann in dem Prüfgerät 114 gespeichert, da das Ausgangssignal am Anschluß 184 verzögert erscheint, da es in dem Register 23 für einen späteren Zeitpunkt gespeichert war. Daher werden die Ausgangssignale an den Anschlüssen 168 und 174 verschoben und gespeichert, bis das Ausgangssignal am Anschluß 184 erscheint. Zu diesem Zeitpunkt werden die drei Ausgangssignale mit den erwarteten verglichen.

Wenn nach dem Testen der Dateneingänge (Anschlüsse 148, 152 und 156) des Übertragungsweges 16' zur Prüfung seiner Steuereingänge (Anschlüsse 150, 154 und 158) ein 1-Signal dem Eingangsanschluß 130 zugeführt wird und das Ausgangssignal ein 0-Signal ist, ist der Übertragungsweg nicht fehlerhaft, da das Null-Signal das erwartete ist.

Während die PLA 15 und der Übertragungsweg 16' nacheinander geprüft wurden, wird der Übertragungsweg 17 parallel mit der PLA 14' geprüft. Während der Übertragungsweg 16' daher zu einem anderen Zeitpunkt geprüft werden mußte als die PLA 15, ist der Übertragungsweg 17 parallel dargestellt, so daß er gleichzeitig mit der PLA 14' geprüft werden kann. Es sei bemerkt, daß das Register 21 auch eine logische Funktion ausführt und nicht lediglich für das Prüfen vorgesehen ist. Das spezielle Register 21 ist, wenn es in Verbindung mit der PLA 14' benutzt wird, tatsächlich ein Zähler.

Gleichzeitig mit dem Ausgeben des Inhalts des Registers 21 in die PLA 14' wird der Inhalt auch dem Übertragungsweg 17 über die Leitung 223 und den Anschluß 228 sowie über die Leitung 222 und den Anschluß 224 zugeführt. Das über den Anschluß 130 zugeführte Steuersignal, das gleichzeitig den Übertragungsweg 16' steuert, steuert die PLA 14', in dem sie sie über den Anschluß 208 aktiviert, so daß das Prüfmuster nach Durchlaufen der PLA auf die Leitungen 209, 211, 213 und 215 für die Eingabe in das Register 21 ausgelesen wird. Das Eingangssignal (1) am Anschluß 132 sperrt den Übertragungsweg 17. Das Steuersignal (1) am Anschluß 130 gibt den Übertragungsweg 16' frei und sperrt die PLA 14'.

Um die PLA 14' zu prüfen, wird sie aktiviert und das Register 21 und die PLA 14' bilden einen Zähler. Beim Ausschieben des Inhaltes des Registers 21 wird das Ausgangsmuster auch auf die Leitung 240 ausgegeben, die zum Anschluß 242 des Registers 25 führt, aus dem es über den Anschluß 254 in das Register 23 gelangt, von dem aus es über die Leitung 180 und die Ausgangs-Treiberschaltung 182 zum Anschluß 184 gelangt. Dies stellt eine Prüfung für die PLA 14' dar.

Es sei bemerkt, daß zur Prüfung der PLA 14' nur ein Anschluß 134 verfügbar ist, daher müssen die Ausgangssignale an den Anschlüssen 168 und 174 verzögert werden bis zum Auftreten des Ausgangssignals am Anschluß 184, um den Vergleich durchzuführen.

Zum Prüfen des Übertragungsweges 17, der parallel und gleichzeitig mit der PLA 14' arbeitet, wird das Muster nach Spalte 18 eingegeben und erscheint als Ausgangsmuster auf den zu den Verbindungspunkten 160 und 162 führenden Leitungen 232 und 234. Das dem Anschluß 130 zugeführte Steuersignal besitzt einen solchen Wert, daß der Übertragungsweg 16' gesperrt ist und die Ausgangssignale des Übertragungsweges 17 über die Ausgangs-Treiberschaltungen 166 und 172 an den Anschlüssen 162 und 174 erscheinen. Es sei bemerkt, daß, da die Prüfung des Übertragungsweges 17 und die Prüfung der PLA 14' voneinander unabhängig erfolgen, die Ausgangssignale in dem Prüfgerät nicht gespeichert zu werden brauchen, um auf Ausgangssignale von anderen Anschlüssen zu warten, sondern daß die Prüfung unmittelbar erfolgen kann.

Da die Prüfmuster für den Übertragungsweg 17 und die PLA 14' parallel zugeführt werden und die Prüfung unabhängig voneinander erfolgt, kann die in Spalte 20 der Tabelle III angegebene Prüfung eliminiert werden und stattdessen das Prüfmuster nach Spalte 14' gleichzeitig für die Prüfung des Übertragungsweges und der PLA 14' benutzt werden.

Um die Steuereingänge 226 und 230 des Übertragungsweges 17 darauf zu prüfen, ob sie infolge eines Fehlers ständig das Binärsignal Null aufweisen, wird ein 1-Signal dem Steuereingang 132 zugeleitet, das über die Anschlüsse 226 und 230 zum Übertragungsweg 17 gelangt. Gleichzeitig nehmen die den Anschlüssen 150, 154 und 158 des Übertragungsweges 16' zugeführten Eingangssignale ihren steuernden Wert an, wodurch auf den Leitungen 159 und 161 ein Null-Signal erscheint. Daher können die Anschlüsse 226 und 230 dadurch darauf überprüft werden, ob sie infolge eines Fehlers ständig das Binärsignal Null aufweisen, daß die Ausgangssignale den Leitungen 232 und 234 zugeführt werden, über die sie an die Anschlüsse 168 und 174 gelangen.

Nachdem das Muster nach Spalte 13 über den Anschluß 134 und die Leitung 198 dem Register 21 zugeführt wurde, signalisiert der Taktimpuls am Anschluß 138 dem Register, seinen Inhalt auf die Leitungen 200, 202, 204 und 206 zu übertragen. Gleichzeitig wird ein Ausgangssignal auf der Leitung 240 erzeugt und dem Register 25 über den Anschluß 242 zugeführt. Beim nächsten am Anschluß 138 erscheinenden Taktimpuls erhält das Register 25 über den Anschluß 244 ein Eingangssignal und erzeugt ein Ausgangssignal, das dem Register 23 über den Anschluß 254 zugeführt wird und nach dem Durchlaufen des Registers 23 über die Leitung 180 zum Anschluß 184 gelangt.

Um die Ausgangs-Treiberschaltungen 263 und 265 zu prüfen, wenn das Ausgangsmuster der PLA 14' auf den Leitungen 209, 211, 213 und 215 zur Weiterleitung in das Register 21 erscheint, erscheinen gleichzeitig Signale auf den Leitungen 221 und 222, die dem Register 25 über die Anschlüsse 248 und 250 zugeführt werden. Das Register 25 liefert auf die Eingangssignale für die Ausgangs-Treiberschaltungen 263 und 265. Diese können geprüft werden beim Verschieben des Signals durch das Register 25. Beim nächsten System-Taktpuls am Eingangsanschluß 136 erscheint ein Eingangssignal am Anschluß 246 des Registers 25, das ein Ausgangssignal dem Eingangsanschluß 262 der Ausgangs-Treiberschaltung 263 zuführt, die ein Ausgangssignal am Anschluß 266 erzeugt. Gleichzeitig wird ein Ausgangssignal dem Anschluß 264 der Ausgangs-Treiberschaltung 265 zugeführt, die ein Ausgangssignal am Anschluß 268 erzeugt. Die Werte an den Ausgangsanschlüssen 266 und 268 werden mit den anderen Ausgangssignalen in dem Prüfgerät 114 kombiniert, um als Ausgangsmuster mit dem erwarteten Ausgangsmuster verglichen zu werden.

Durch Anordnung der Übertragungswege und der PLA in der oben beschriebenen Weise können die PLA parallel geprüft werden, vorausgesetzt, daß, wenn eine Eingangsverzweigung vorliegt, die Ausgänge nicht miteinander verbunden sind. Wenn andererseits die Ausgänge miteinander verbunden sind, darf keine Eingangsverzweigung vorliegen. Nur unter diesen Bedingungen stören sich die Muster nicht.

Es sei bemerkt, daß für das Ausführungsbeispiel nach Fig. 2 das dem Anschluß 132 zugeführte Eingangssignal, das dem Übertragungsweg 17 zugeleitet wird, einen Wert aufweisen muß, der keine Steuerung bewirkt, um das Muster für die PLA 14' verträglich mit der PLA 15 zu machen, d. h. das Eingangssignal für den Anschluß 132 muß ein Null-Signal sein, wie das in den Spalten 13—17 angegeben ist. Daher können die Muster nicht parallel ausgegeben werden, da sie sich stören würden. Wenn jedoch die beiden PLA Muster sich nicht stören, können die Muster kombiniert werden für den Parallelbetrieb.

Durch Anordnen der PLA und der Übertragungswege in der beschriebenen Weise wird das Prüfen eingebetteter PLA viel einfacher als das Prüfen der elementaren Verknüpfungsglieder und es wird sehr viel Zeit bei der Erzeugung der Prüfmuster eingespart.

In den Fig. 1 und 2 können die PLA ersetzt werden durch irgendeine allgemeine Makro-Struktur, die eine nichtlineare logische Funktion ausführt, wie z. B. eine allgemeine arithmetische und logische Einheit oder eine allgemeine Einheit für die Steuerlogik. In ähnlicher Weise kann eine logische Makro-Struktur, die eine lineare logische Funktion ausführt, an die Stelle der Übertragungswege treten, um die 1 : 1 Abbildung vorzunehmen.

## Patentansprüche

1. Halbleiterchip mit verbesserter Prüfbarkeit der monolithisch hochintegrierten Schaltungen, das eingebettete, d. h. von den Eingangs- und Ausgangsanschlüssen des Halbleiterchips direkt nicht zugängliche sogenannte programmierbare logische Anordnungen (12, 14; 14', 15) sowie lineare logische Funktionen realisierende Schaltungen und der Aufnahme von Prüfbitmustern und Prüfergebnissen dienende Schieberegister (18, 20; 21, 23, 25) enthält, dadurch gekennzeichnet, daß die Ausgänge eines Teils der programmierbaren logischen Anordnungen (12, 14, 15) mit einem über Verknüpfungsglieder schaltbaren ersten Übertragungsweg (16; 16') verbunden sind, so daß die im Prüfbetrieb an den Ausgängen dieser programmierbaren logischen Anordnungen erscheinenden Prüfergebnisse als Prüfbitmuster für die Verknüpfungsglieder des zugehörigen schaltbaren Übertragungsweges dienen.

2. Halbleiterchip nach Anspruch 1, dadurch gekennzeichnet, daß die Ausgänge des ersten Übertragungsweges (16') mit den entsprechenden Ausgängen eines ebenfalls über Verknüpfungsglieder schaltbaren zweiten Übertragungsweges (17) verbunden sind und jeweils nur die Verknüpfungsglieder eines der Übertragungswege durchgeschaltet sind, um die Prüfergebnisse an von beiden Übertragungswegen gemeinsam benutzte Einrichtungen zur Weitergabe der Prüfergebnisse (163, 164, 166, 168, 162, 165. 170, 172, 174) weiterzuleiten.

3. Halbleiterplättchen nach Anspruch 1 oder 2, dadurch gekennzeichnet, daß die Prüfbitmuster für eine programmierbare logische Anordnung (14') auch als Prüfbitmuster für einen nicht auf sie folgenden schaltbaren Übertragungsweg (17) dienen.

**0 010 173**

### Claims

1. Semiconductor chip with improved ability to test of monolithic large scale integrated circuits, comprising embedded programmable logic arrays (12, 14; 14', 15) which are not directly accessible from the input and output terminals of the semiconductor chip, as well as circuits performing linear logic functions and shift registers (18, 20; 21, 23, 25) serving to accommodate test bit patterns and test results, characterized in that the outputs of part of the programmable logic arrays (12, 14; 15) are connected to a first bus (16; 16'), switchable by logic elements, so that the test results occuring at the outputs of these programmable logic arrays during the test mode serve as test bit patterns for the logic elements of the pertinent switchable bus.

2. Semiconductor chip according to claim 1, characterized in that the outputs of the first bus (16') are connected to corresponding outputs of a second bus (17) which is also switchable by logic elements, and only the logic elements of one of the buses are switched to propagate the test results to means (163, 164, 166, 168, 162, 165, 170, 172, 174) commonly used by roth buses and serving to transmit the test results.

3. Semiconductor chip according to claim 1 or 2, characterized in that the test bit patterns for a programmable logic array (14') also serve as test bit patterns for a bus (17) other than following this array.

### Revendications

1. Microplaquette semi-conductrice permettant un test amélioré des circuits monolithiques à haute densité d'intégration, et comportant des ensembles logiques programmables (12, 14; 14', 15), c'est-à-dire n'étant pas directement accessibles à partir des connexions d'entrée et de sortie de la microplaquette semi-conductrice, des circuits réalisant des fonctions logiques linéaires, ainsi que des registres à décalage (18, 20; 21, 23, 25) pour recevoir des configurations de bit de test et des résultats de test, caractérisée en ce que les sorties d'une partie des ensembles logiques programmables (12, 14; 15) sont connectées à un premier bus de transition (16; 16') commutable au moyen d'éléments logiques de telle sorte que les résultats des tests apparaissant en mode de test sur les sorties de ces ensembles logiques programmables servent de configuration de bits de test pour les éléments logiques du bus de transmission commutable associé.

2. Microplaquette semi-conductrice selon la revendication 1, caractérisée en ce que les sorties du premier bus de transmission (16') sont connectées aux sorties correspondant du second bus de transmission (17) qui est également commutable au moyen d'éléments logiques et, en ce que seulement les éléments logiques de l'un des bus de transmission sont commutés afin de transmettre les résultats de test à des dispositifs (163, 164, 166, 168, 162, 165, 170, 172, 174) utilisés en commun par les deux bus et servant à transmettre les résultats de test.

3. Microplaquette semi-conductrice selon la revendication 1 ou 2, caractérisée en ce que les configurations de bits de test pour un ensemble logique programmable (14') servent également de configurations de bits de test pour un bus de transmission (17) commutable qui ne suit pas cet ensemble.

13

FIG. 1

**FIG. 2**

208 210 212 214 216 209 211 213 215

300

302

302

SUCH – ANORDNUNG LESE – ANORDNUNG

# FIG. 3

146 144 143 142 140

304 304

300 DOPPELBIT - UNTERTEILGS NETZWERK DOPPELBIT- UNTERTEILGS. NETZWERK 149 151 153

302

SUCH – ANORDNUNG LESE-ANORDNUNG

# FIG. 4

FIG. 5